# EUROPÄISCHE PATENTANMELDUNG

(11) **EP 0 823 834 A2**
(43) Veröffentlichungstag der Anmeldung: **11.02.1998**
(21) Anmeldenummer: 97810478.4
(22) Anmeldetag: 14.07.1997
(51) Int. Cl.: H05K 5/00

(54) **Einbaumodul**

(30) Priorität: 05.08.1996 CH 1929/96
(71) Anmelder: EDAK AG, CH-8447 Dachsen (CH)
(72) Erfinder: Spitznagel, Hans, 8462 Rheinau (CH); Prechtl, Robert, 81827 München (DE)
(74) Vertreter: Patentanwälte Breiter + Wiedmer AG

(57) **Zusammenfassung**

Ein als geschlossenes, stabiles Schutzgehäuse (14) oder teilweise offenes Stützelement mit Frontplatte ausgebildetes Modul (12) ist zu einem selbsttragenden Modulaufbau (10) stapelbar und/oder in ein Gestell einbaubar. Es dient der Aufnahme elektrischer und elektronischer Einbauteile und -geräte mit wenigstens einer paarweisen Steckverbindung für elektrische oder optische Leiter. Die Steckverbindungen eines Einbaumoduls (12) sind in seitlichem Abstand (a) auf zwei parallelen, schrägen Ebenen (E1,E2) nebeneinander oder auf einer parallel zur Rückseite (18) des Einbaumoduls (12) verlaufenden Ebene (E3) angeordnet. Wenigstens eines der Gegenstücke (30,32) zum Stecken in das entsprechende andere Gegenstück (32,30) eines benachbarten Einbaumoduls (12) ist entlang der betreffenden Ebene (E1,E2) in eine arretierbare Position verschiebbar. Gestapelte, im Bereich der Ecken lösbar verschraubte Einbaumodule (12) aus einem stabilen Schutzgehäuse aus Leichmetall können zu einem Modulaufbau (10) gestapelt werden. Dieser Modulaufbau kann zur Schockund Vibrationsabsorption über elastische Puffer, vorzugsweise über vier schräg an den Ecken montierte Gummipuffer, auf einer Bodenplatte (22) gelagert werden.

## Beschreibung

Die Erfindung bezieht sich auf ein als geschlossenes, stabiles Schutzgehäuse oder teilweise offenes Tragelement mit Frontplatte ausgebildetes Modul, welches zu einem selbsttragenden Modulaufbau stapelbar und/oder in ein Gestell einbaubar ist, für elektrische und elektronische Einbauteile und -geräte mit wenigstens einer paarweisen Steckverbindung für elektrische oder optische Leiter.

Sowohl als Schutzgehäuse als auch als Tragelemente mit Frontplatte ausgebildete Module sind in zahlreichen Ausführungsformen an sich bekannt, eingeschlossen Varianten mit die Zugänglichkeit verbessernden, ausziehbaren Schubladen.

Eine erste Variante des Moduls mit einem geschlossenen, stabilen Schutzgehäuse wird bei extremen mechanischen, chemischen und/oder klimatischen Beanspruchungen eingesetzt. Das bevorzugt aus Leichtmetall, insbesondere Aluminium, hergestellte Gehäuse dient der Abschirmung der elektronischen Baugruppen gegen hochfrequente Fremdfeldeinwirkung, schützt aber auch gegen Staub und Wasser. Dies ist beispielsweise beim Einsatz für militärische Zwecke, auf Nutzfahrzeugen, im Bergbau usw. von Bedeutung.

Nach einer zweiten Variante kann das Modul bei Normalbedingungen auch als teilweise offenes Stützelement mit einer Frontplatte ausgebildet sein, welche in ein Gestell einbaubar ist. Die Frontplatte kann fest mit dem auch Rack genannten Gestell verschraubt oder als Schublade mit vorzugsweise teleskopartigen Schienen ausziehbar sein, was die Module frei zugänglich macht. In der Frontplatte sind in üblicher Weise Bedienungs- und Anzeigeorgane angeordnet.

Alle Arten von Einbaumodulen können einzeln oder gruppenweise in einem Traggehäuse, z.B. gemäss der EP,B1 0068125, der EP,A2 0327809 oder der Firmenschrift "Milex-Traggehäuse mag kommen was will" (1996) der Edak AG, CH-8447 Dachsen, angeordnet sein, falls dies die mechanische, chemische und/oder klimatische Beanspruchung erfordert. Selbstverständlich sind geschlossene, stabile Schutzgehäuse wesentlich widerstandsfähiger als teilweise offene Stützelemente mit Frontplatte und werden in der Regel nur bei extremsten Bedingungen zusätzlich geschützt.

Sowohl geschlossene, stabile Schutzgehäuse als auch teilweise offene Stützelemente mit Frontplatte beinhalten zahlreiche elektrische Leiter, welche der Stromspeisung und insbesondere der Verbindung mit elektronischen Baugruppen anderer Module dienen. Die aus der geschlossenen oder offenen Rückseite der Module austretenden elektrischen Leiter führen zu einem unübersichtlichen "Kabelsalat". Die Gefahr eines Fehlsteckens von paarweisen Steckverbindungen ist stets systeminhärent. Bei optischen Leitern gilt sinngemäss entsprechendes.

Bei geschlossenen Schutzgehäusen müssen die elektrischen oder optischen Leiter für andere Module vorerst aus dem Gehäuse heraus und dann wieder in ein Gehäuse hineingeführt werden, was die Abdichtung gegen Staub und Wasser zusätzlich erschwert.

Der Erfindung liegt die Aufgabe zugrunde, ein Einbaumodul der eingangs genannten Art zu schaffen, welches aus der Rückseite austretende elektrische oder optische Leiter weitgehend oder vollständig vermeidet, Fehlsteckungen von Steckverbindungen praktisch verhindert und einfach zu bedienen ist.

Die Aufgabe wir erfindungsgemäss dadurch gelöst, dass die Steckverbindungen eines Einbaumoduls in seitlichem Abstand auf zwei parallelen, schrägen Ebenen nebeneinander oder auf einer parallel zur Rückseite des Einbaumoduls verlaufenden Ebene angeordnet sind, wobei wenigstens eines der Gegenstücke zum Stecken in das entsprechende andere Gegenstück eines benachbarten Einbaumoduls entlang der betreffenden Ebene in eine arretierbare Position verschiebbar ist. Spezielle und weiterführende Ausbildungsformen der Erfindung sind Gegenstand von abhängigen Patentansprüchen.

Mit dem erfindungsgemässen Einbaumodul besteht erstmals die Möglichkeit, mit wenigstens einem Paar von Steckverbindungen vielpolige Gegenstücke einzusetzen, welche die auf der Rückseite geführten Kabel, Litzen und Drähte, also alle elektrischen oder optischen Leiter, durch eine im Innern geführte Steckverbindung ersetzen. Dies ist auch schon mit anderen Mitteln zu realisieren versucht worden. Den Durchbruch zum Erfolg brachte erstmals eine Ausführungsform mit auf zwei parallelen schrägen Ebenen liegenden Gegenstücken der Steckverbindung, wovon wenigstens eines in Steckrichtung verschiebbar ist. Diese Schrägstellung erlaubt es beispielsweise, bei der Montage der Einbaumodule zu einem Modulaufbau einen Stecker (Plug) automatisch in eine Steckdose (Socket) des nächstfolgenden Moduls einzuführen. Beispielsweise kann ein 156-poliger ZIF-Connector der Firma ITT Cannon eingesetzt werden.

Die beiden Gegenstücke der Steckverbindung müssen so geneigt sein, dass sie oder ihre Verlängerungen nebeneinander liegen. Dies ist in der Praxis der Fall, wenn der Neigungswinkel a gegenüber der Rückseite des Einbaumoduls wenigstens etwa 10° beträgt. Andererseits soll dieser Winkel a nicht grösser als etwa 45° sein, weil sonst immer mehr Einbauraum für die Elektronik im Innern des Einbaumoduls verloren ginge.

Der seitliche Abstand der beiden Gegenstücke der Steckverbindung liegt ebenfalls wegen der Raumausnutzung zweckmässig bei höchstens etwa 20 mm.

Nach einer Variante der Erfindung können die Gegenstücke bei einem mit hinreichendem Einbauraum ausgestatteten Einbaumodul auf einer parallel zur Rückwand verlaufenden Ebene angeordnet sein. In diesem Fall kann ein in Steckrichtung verschiebbares Gegenstück von aufeinander gestapelten Einbaumodulen nicht mit einfachen Mitteln positioniert werden. Das Verschieben kann manuell z.B. nach dem Abheben des Stapels an der betreffenden Stelle oder mit einem durch einen Gehäuseschlitz geführten Werkzeug erfolgen. Kompliziert ist der Einsatz von motorischen oder elektromagnetischen Verschiebekräften für ein bewegliches Gegenstück.

Die Gegenstücke der Steckverbindung sind vorzugsweise als Stecker und Steckdose, Stiften- und Buchsenleiste oder als Federleisten ausgebildet. Die eigentlichen Kontakte sind als ineinandergeführte Stiften und Buchsen oder als aufeinandergedrückte Kontaktplättchen ausgebildet. Der Stecker kann Stiften oder Buchsen enthalten, ebenso die Steckdose Buchsen oder Stiften.

Obwohl im Prinzip beide Gegenstücke der Steckverbindung in Richtung der zugeordneten Ebene längsverschiebbar sein können, ist vorzugsweise ein Gegenstück unbewegbar montiert, das andere Gegenstück ist nach dem Aufeinanderlegen der betreffenden Aufbaumodule in Axialrichtung verschiebbar, bis die Steckverbindung hergestellt ist. Dabei ragt das verschobene Gegenstück der Steckverbindung in das benachbarte Einbaumodul hinein und ist dort arretiert.

Bei der Montage oder Demontage eines Modulaufbaus werden die Steckverbindungen stufenweise durch Verschieben und Arretieren des verschiebbaren Gegenstücks hergestellt oder gelöst. Eine charakteristische Umrandung und/oder eine Codierung der Gegenstücke können gewährleisten, dass die Einbaumodule in der vorausgeplanten Reihenfolge aufeinander gesetzt und die richtigen Steckverbindungen hergestellt werden. Beim Auswechseln eines Einbaumoduls müssen vorerst die benachbarten Module entfernt werden, jeweils mit vorhergehender Lösung der Steckverbindung. Nach einer Variante können die Steckverbindungen von aussen hergestellt und gelöst werden, z.B. durch die Rückseite. Nach dem Lösen der betreffenden Steckverbindungen sind einzelne Ausbaumodule oder allfällige Schubladen herausziehbar.

Es ist bereits erwähnt worden, dass anstelle von elektrischen optische Verbindungen hergestellt werden, statt Kupferdrähten oder -litzen werden dann Glasfasern oder dgl. eingesetzt.

Selbstverständlich können auch mehrere Steckverbindungen mit je einem Paar von ineinanderschiebbaren Gegenstücken ausgebildet sein. Bevorzugt ist jedoch ein Paar von grossen Gegenstücken, welche die Steckverbindung bilden.

Die erfindungsgemässen Einbaumodule sind für ausgereifte Anwendungen gedacht. Im Experimentierstadium für eine Neuentwicklung werden die zahlreichen elektrischen Leiter weiterhin in Kauf genommen, weil sie jederzeit umgesteckt werden können.

Unter Normalbedingungen stationär gebrauchte Einbaumodule können ohne weiteres zu einem Modulaufbau verschraubt oder aneinanderliegend in einem Gestell eingebaut sein. In korrosiver und/oder feuchter Atmosphäre werden bevorzugt geschlossene, stabile Schutzgehäuse eingesetzt. Diese zu einem Modulaufbau gestapelten Einbaumodule haben zweckmässig stabile Schutzgehäuse aus Leichtmetall, insbesondere Aluminium. Bei Gefahr von Schockeinwirkungen oder Vibrationen sind zusätzlich vorzugsweise vier an einer Bodenplatte gelagerte elastische Puffer vorgesehen. Diese sind an den Ecken schräg nach innen weisend montiert und mit dem untersten Einbaumodul verbunden.

Ist eine extrem hohe mechanische, chemische und/oder klimatischen Beanspruchung zu erwarten, können alle Arten von Einbaumodulen, also auch mit einem Schutzgehäuse versehene, in einen zweckmässig tragbaren Koffer mit einem Schwingrahmen für elektrische und elektronische Geräte eingebaut werden. Wie bereits erwähnt, sind diese nicht Bestandteil der Erfindung bildenden Schutzgehäuse in der EP,B1 0068125 und der EP,A2 0327809 beschrieben, es wird jedoch ausdrücklich darauf verwiesen, ebenso auf die Firmenschrift "Milex-Traggehäuse mag kommen was will" (1996) der Firma Edak AG, CH-8447 Dachsen.

Die Vorteile der Erfindung können kurz wie folgt zusammengefasst werden:
- Die überall aus der Rückseite von Einbaumodulen heraushängenden elektrischen oder optischen Kabel können durch eine Steckverbindung innerhalb der Einbaumodule ersetzt werden, was eine Dichtungsfunktion erlaubt und Fehlsteckungen praktisch eliminiert.
- Eine ausschliesslich modulinterne Verkabelung ist gewährleistet.
- Der ästhetische Anblick eines Modulaufbaus wird entscheidend verbessert.
- Die einzelnen Module können in einem Koffer zum Transportieren zusammen mit Werkzeugen, Montageanleitung und dgl. gelagert, transportiert und montiert werden, ohne ganze Sortimente von Kabeln administrieren zu müssen.

Die Erfindung wird anhand von in der Zeichnung dargestellten Ausführungsbeispielen, welche auch Gegenstand von abhängigen Patentansprüchen sind, näher erläutert. Es zeigen schematisch:
- Fig. 1 eine Seitenansicht (Schnittbild) eines Modulaufbaus mit schräg fluchtenden Gegenstücken,
- Fig. 2 eine verfeinert dargestellte Variante gemäss Fig. 1,
- Fig. 3 eine Draufsicht auf ein Einbaumodul gemäss Fig. 2,
- Fig. 4 vergrössert dargestellte Gegenstücke einer Steckverbindung, und
- Fig. 5 einen Modulaufbau gemäss Fig. 1 im Bereich der Rückwand mit vertikal fluchtenden Gegenstücken.

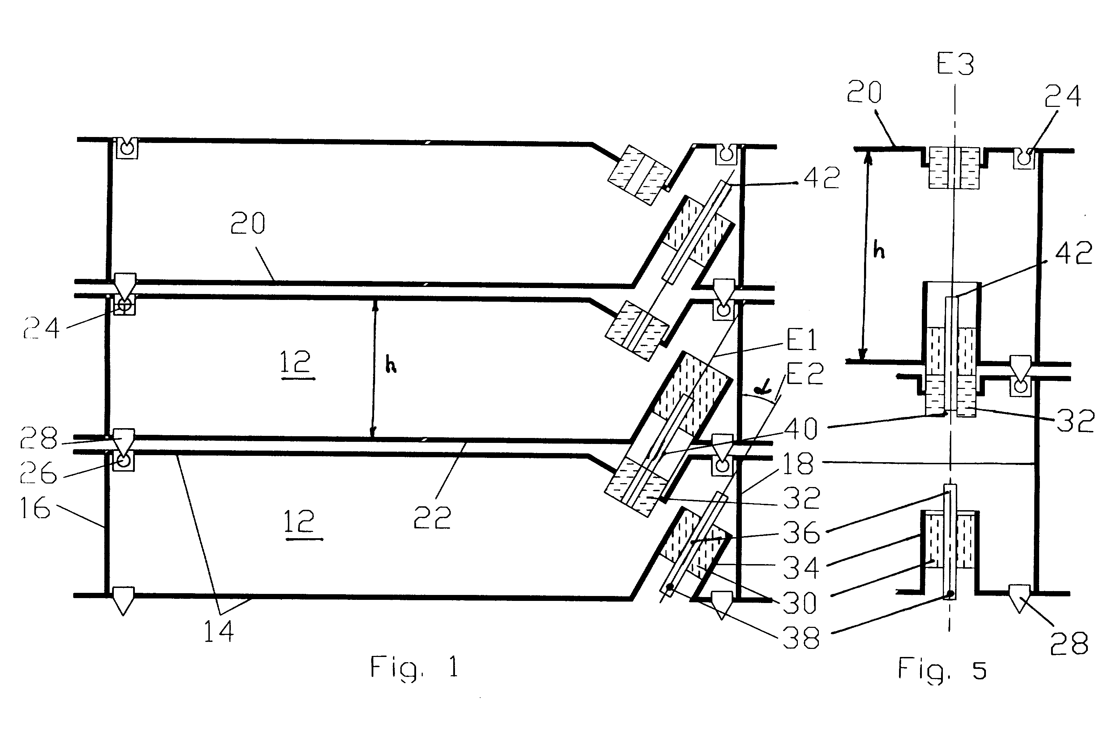

Ein in Fig. 1 dargestellter Ausschnitt aus einem Modulaufbau 10 zeigt zwei vollständig und zwei teilweise dargestellte Einbaumodule 12, welche ein geschlossenes, stabiles Schutzgehäuse 14 mit einer Frontseite 16 und einer Rückseite 18 umfasst. Im vorliegenden Fall hat das Schutzgehäuse 14 einen freien Einbauraum für die Elektronik einer Breite von 270 mm, einer Höhe von 42 mm und einer Tiefe von 220 mm. Die entsprechenden Aussenmasse für das Einbaumodul betragen 300 x 300 x 60 mm. Diese Dimensionen können über einen breiten Bereich variiert werden.

Die Schutzgehäuse 14 bestehen aus Aluminium und haben einen abhebbaren Deckel 20. Dieser hat eine entlang des Umfangs umlaufende Nut 24 in welcher eine EMI-Dichtung 26 (EMI = elektromagnetische Interferenz) aus einem elektrisch leitenden Elastomer eingelegt ist. Diese Dichtung ist in elektrischem Kontakt mit dem Gehäuse 14 und über einen umlaufenden metallischen Führungskamm 28 mit dem benachbarten Einbaumodul 20 verbunden. Dadurch ist jedes Gehäuse vollständig gegen EMI-Störungen abgedichtet.

Im Bereich der Rückseite 18 jeden Einbaumoduls 12 ist auf parallelen schrägen Ebenen El, E2 je ein Gegenstück 30, z.B. ein Stecker, und 32, z.B. eine Steckdose, angeordnet. Im vorliegenden Fall sind die Gegenstücke 30, 32 ein ZIF-Connector mit 156 Polen. Sie sind, in Fig. 1 nicht erkennbar, im Querschnitt langrechteckig ausgebildet.

Das erste Gegenstück 30, gezeichnet als Stecker, verläuft mit wenig Spiel in einer Steckerhülse 34 mit Führungseigenschaften, er ist entlang der Ebenen E1, E2 verschiebbar. Der Stecker hat einen beidseits überstehenden Führungsstift 36 mit einem Verriegelungsnocken 38.

Das zweite Gegenstück 32, gezeichnet als eine Steckdose, hat eine Bohrung 40 für den Führungsstift 36 mit einer längslaufenden Nut für den Verriegelungsnocken 38. Benachbart der blinden Ende der als Sackloch ausgebildeten Bohrung 40 verläuft eine aus der Bohrungswandung ausgesparte Ringnut, in welche der Verriegelungsnocken 38 beim Erreichen der Endposition des Steckers 30 gedreht werden kann. Diese Ringnut kann sich in von der längslaufenden Nut wegweisender Richtung verengen, so dass der Verriegelungsnocken 38 beim Drehen des Führungsstiftes 36 in der Endposition verklemmt wird und fest sitzt.

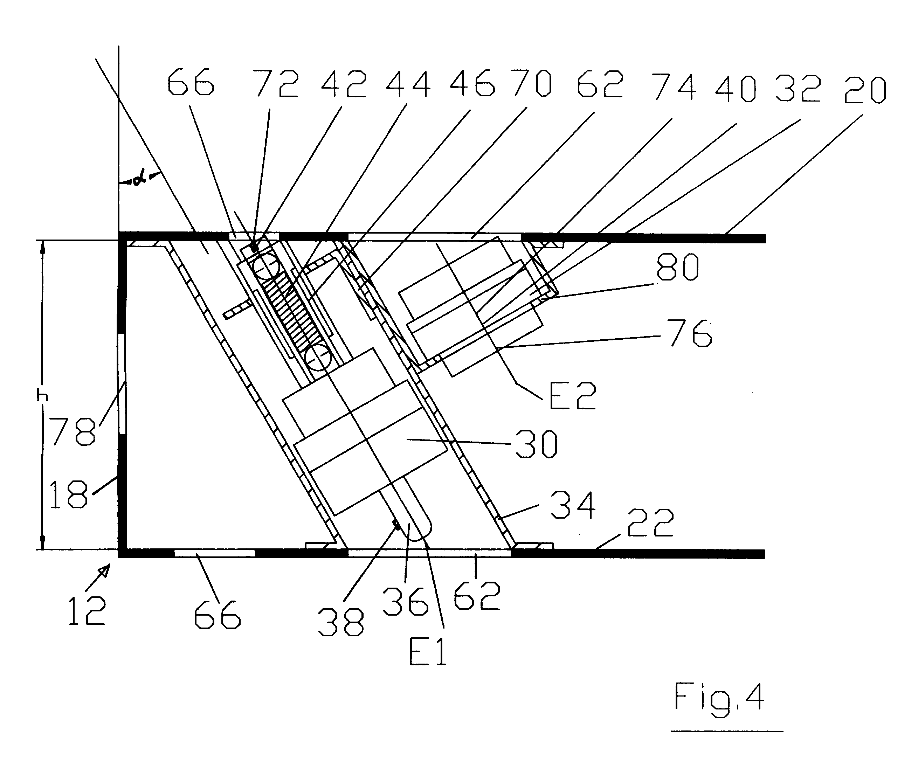

Der Führungsstift 36 weist am oberen stirnseitigen Ende 42 einen Schlitz für einen Schraubenzieher, ein Sechskantloch für einen Imbusschlüssel oder einen Sechskantkopf für einen entsprechenden Steckschlüssel auf. Mit einem dieser Werkzeuge kann der Stecker 30, vorzugsweise gegen den Widerstand von wenigstens einer Feder 44 (Fig. 4) nach unten gedrückt und durch Drehen arretiert werden.

Die parallelen schrägen Ebenen E1, E2 haben gegenüber der Rückseite 18 einen Neigungswinkel α von etwa 30°.

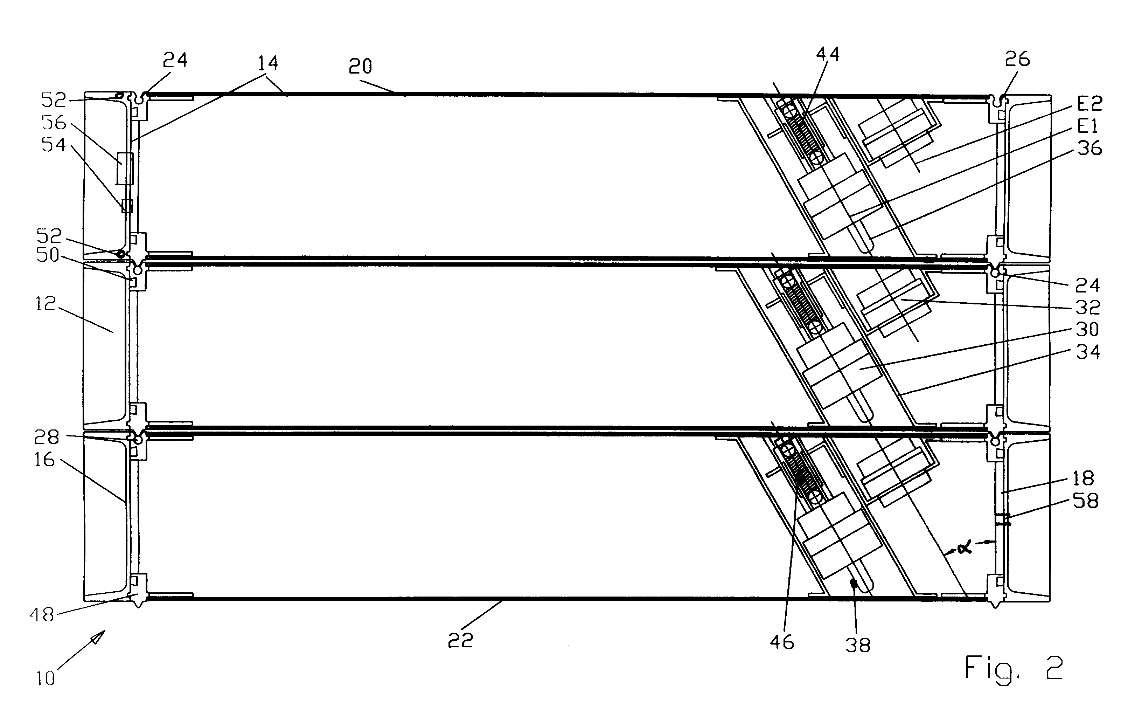

In Fig. 2 sind drei miteinander verschraubte Einbaumodule 12 zu einem Modulaufbau 10 vereinigt. Die erfindungsgemässen Steckverbindungen aus zwei Gegenstücken 30, 32 sind wiederum auf zwei parallelen schrägen Ebenen E1, E2 angeordnet. Die Neigung der Ebenen beträgt bezüglich der Rückseite 18 eines Einbaumoduls 12 wieder etwa 30°, die Stecker sind jedoch beim Herstellen der Steckverbindung in Richtung der Rückseite 18 des Einbaumoduls 12 verschiebbar. Die Steckerführung erfolgt jedoch nicht durch die Steckerhülse 34, sondern über eine Teleskopführung 46 mit zwei Federn 44 als Rückholorgan. Die Steckverbindungen mit den Gegenstücken 30, 32 sind in Fig. 4 detailliert dargestellt.

Das Schutzgehäuse 14 ist zerlegbar ausgebildet. Der Boden 22 ist mit einem unteren Führungsrahmen 48 verschweisst, welcher einen sich nach unten stark verjüngenden Führungskamm 28 aufweist. Der abhebbare Deckel 20 umfasst einen oberen Führungsrahmen 50 mit der unten im Querschnitt kreisförmigen, umlaufenden Nut 24 welche die EMI-Dichtung 26 enthält.

Die Frontseite 16 und die Rückseite 18 sind über Steckbolzen 52 gehaltert.

In der Frontseite 16 sind in üblicher Weise Bedienungsorgane 54 und/oder Anzeigeorgane 56 integriert. Selbstverständlich können diese beliebig angeordnet, aber auch vollständig weggelassen sein. Die Rückseite 18 ist wenigstens teilweise durch Bohrungen 58 perforiert. Ihr Durchmesser von etwa 2 mm isoliert elektromagnetische Wellen bis etwa 1 GHz.

Je nach Anforderung kann der Modulaufbau 10 gemäss Fig. 2 beim obersten Einbaumodul 12 eine nicht dargestellte magnetische Abdichtung, beim untersten Einbaumodul 12 zusätzlich einen Schockabsorber und Vibrationsschutz in Form von elastischen Puffern haben.

Bei extremen mechanischen (Vibrationen, Schock), chemischen und/oder klimatischen (Feuchtigkeit, Wärme) Bedingungen sowie bei elektromagnetischen Störungen kann der Modulaufbau gemäss Fig. 2 auch in einer Schutzkiste mit einem Schwingrahmen montiert werden, wie dies bei der Würdigung des bekannten Standes der Technik dargelegt worden ist.

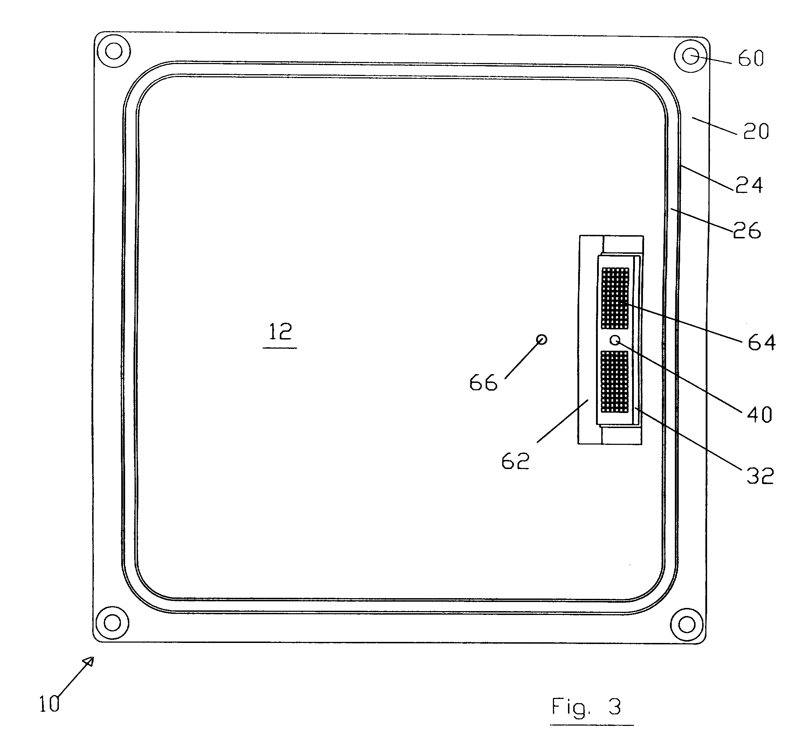

Fig. 3 zeigt eine Draufsicht auf ein Einbaumodul 12 gemäss Fig. 2, in welcher insbesondere der quadratische Deckel 20 dargestellt ist. Die entlang des Umfangs ausgesparte Nut 24 enthält die EMI-Dichtung 26. Die Nut 24 dient auch als Führungsnut zum Stapeln der Einbaumodule 12 und ist mit dem Führungskamm 28 (Fig. 1, 2) als Passitz ausgebildet. Uebereinanderliegende Einbaumodule 12 werden im Eckbereich miteinander verbunden. In den vier Eckbereichen ist je eine mechanische Gehäuseverriegelung 60 angedeutet.

Durch eine langrechteckige Oeffnung 62 im Deckel 20 ist das fest montierte Gegenstück 32 der Steckverbindung, eine Buchsenleiste, erkennbar. Die elektrischen Kontakte 64 können jedoch nicht nur als Buchsen, sondern auch als Stifte oder Kontaktplättchen ausgebildet sein. Das andere Gegenstück 30 (Fig. 1, 2) ist entsprechend ausgebildet.

Zwischen den beiden Feldern mit elektrischen Kontakten 64 liegt die Bohrung 40 zur Aufnahme des Führungsstiftes 36 der als anderes Gegenstück 30 (Fig. 1, 2) ausgebildeten Stiftenleiste eines darüberliegenden Einbaumoduls 12.

Eine Bohrung 66 im Deckel 20 dient der Einführung eines Werkzeugs, mit welchem die als Gegenstück 30 (Fig. 1, 2) ausgebildete Stiftenleiste nach unten gedrückt und nach dem Herstellen der Steckverbindung mit dem Gegenstück 32, der Buchsenleiste, des darunterliegenden Einbaumoduls 12 verriegelt wird.

In der detaillierten Darstellung der Steckverbindung von Einbaumodulen 12 gemäss Fig. 4 sind die Rückseite 18, der Deckel 20 und der Boden 22 gestrichelt angedeutet. Die im Querschnitt langrechteckige Steckerhülse 34 ist über einen umlaufenden Flansch 38 mit dem Boden 22 des Einbaumoduls wie angedeutet verschweisst, kann aber auch lösbar verschraubt sein. Der Deckel 20 liegt ohne Verbindung auf und ist abhebbar. Die Neigung der sich über die Höhe h erstreckenden Steckerhülse 34 entspricht derjenigen der parallelen Ebenen E1, E2, welche gegenüber der Rückseite 18 einen Winkel a von etwa 30° einschliessen.

Im obersten Bereich der Steckerhülse 34 ist ein Haltewinkel 70 für eine Teleskopführung 46 des als Stecker ausgebildeten Gegenstückes 30 ausgebildet. Aus Fig. 4 ist klar ersichtlich, dass die Steckerhülse 34 hier keine Führungsfunktion erfüllt. Dies wird ausschliesslich von der an sich bekannten Teleskopführung 46 mit einem Rückholorgan, im vorliegenden Fall zwei aussenliegende, an der Steckerhülse 34 befestigte Federn 44, erfüllt.

Das stirnseitige Ende 42 des Führungsstifts 36 weist einen durchgehenden diagonalen Schlitz 72 auf. Zum Erstellen der Steckverbindung wird beispielsweise ein Schraubenzieher in den Schlitz 72 gesteckt und der Stecker nach unten gedrückt, wobei die Federn 44 gespannt werden. Dabei wird der Führungsstift 36 in die Bohrung 40 des Gegenstücks 32 des nicht dargestellten, untenliegenden Einbaumoduls 12 geführt, wobei der Verriegelungsnocken 38 in einer peripheren Längsnut 74 gleitet. Nach dem Erreichen des Anschlages, mit ineinandergeführten bzw. aufeinandergedrückten elektrischen Kontakten (64 in Fig. 3) hat der Verriegelungsnocken 38 eine Bohrung mit dem Boden der Längsnut 74 entsprechendem Durchmesser erreicht, der Führungsstift 36 kann beispielsweise um 180° gedreht werden. Die Federn 44 ziehen den Verriegelungsnocken auf die schulterförmige Abstufung zwischen der Bohrung 76 mit grösserem Durchmesser und der Bohrung 40 mit kleinerem Durchmesser, was eine stabile Verriegelung bewirkt. Diese Verriegelung kann durch eine Einkerbung in der erwähnten schulterförmigen Fläche verbessert werden.

Bei einem im Modulaufbau 10 (Fig. 1, 2) montierten Einbaumodul 12 mit unten- und obenliegenden weiteren Einbaumodulen kann ein Werkzeug zum Hinunterdrücken und Verriegeln des Gegenstücks 30 durch eine Oeffnung 78 in der Rückseite eingeführt werden. So wird ein Herausnehmen oder Herausziehen eines Einbaumoduls 12 ermöglicht, ohne dass die benachbarten übrigen Einbaumodule 12 aus dem Modulaufbau 10 (Fig. 1, 2) entfernt werden müssen. Anstelle einer Oeffnung 78 kann in der Rückwand auch eine entsprechende Einbuchtung ausgeformt sein, welche die Bohrung 66 im Boden 22 für die Einführung eines Werkzeugs freilegt.

Das Gegenstück 32 ist in einer kürzeren Hülse 80 fest montiert.

In Fig. 5 ist ein Modulaufbau mit Einbaumodulen 12 dargestellt, welcher im Bereich der Rückwand 18 vertikal fluchtende Gegenstücke 30, 32 und eine etwa 50% grössere Höhe h des Einbauraumes (Fig. 4) hat, sonst jedoch Fig. 1 entspricht. Das erste und zweite Gegenstück, als Stecker 30 und Steckdose 32 ausgebildet, sind in einer Ebene E3 angeordnet, welche parallel zur Rückwand 18 verläuft. Der Stecker 30 verläuft mit wenig Spiel in der vertikalen Steckerhülse 34 mit Führungseigenschaften und ist in Richtung der zugeordneten Steckdose 32 mit einer blinden Bohrung 40 für den Führungsstift 36 verschiebbar.

Die vertikal fluchtenden Gegenstücke 30, 32 bedingen gegenüber auf mehreren parallelen Ebenen E1, E2 (Fig. 1) angeordneten Gegenstücken 30, 32 eine grössere Höhe h des Einbauraums 12 und sind nur mit erhöhtem Aufwand aus einem Modulaufbau entfernbar.

Der Vollständigkeit halber sei nochmals erwähnt, dass nach erfindungsgemässen Varianten
- beide Gegenstücke 30, 32 längsverschiebbar sein können, oder
- das Gegenstück 30 (Stecker) fest und das Gegenstück 32 (Steckdose) längsverschiebbar sein kann, wobei die Herstellung der Steckverbindung durch eine Bewegung nach unten, aber auch nach oben, herstellbar ist.

## Patentansprüche

1. Als geschlossenes, stabiles Schutzgehäuse (14) oder teilweise offenes Stützelement mit Frontplatte ausgebildetes Modul (12), welches zu einem selbsttragenden Modulaufbau (10) stapelbar und/oder in ein Gestell einbaubar ist, für elektrische und elektronische Einbauteile und -geräte mit wenigstens einer paarweisen Steckverbindung für elektrische oder optische Leiter,
dadurch gekennzeichnet, dass
die Steckverbindungen eines Einbaumoduls (12) in seitlichem Abstand (a) auf zwei parallelen, schrägen Ebenen (E1,E2) nebeneinander oder auf einer parallel zur Rückseite (18) des Einbaumoduls (12) verlaufenden Ebene (E3) angeordnet sind, wobei wenigstens eines der Gegenstücke (30,32) zum Stecken in das entsprechende andere Gegenstück (32,30) eines benachbarten Einbaumoduls (12) entlang der betreffenden Ebene (E1,E2,E3) in eine arretierbare Position verschiebbar ist.

2. Einbaumodul (12) nach Anspruch 1, dadurch gekennzeichnet, dass die parallelen schrägen Ebenen (E1,E2) der Gegenstücke (30,32) bezüglich der Rückseite (18) des Einbaumoduls (12) in einem Winkel (α) von 10 bis 45°, vorzugsweise von etwa 30°, geneigt sind.

3. Einbaumodul (12) nach Anspruch 2, dadurch gekennzeichnet, dass der seitliche Abstand (a) der Gegenstücke (30,32) bis etwa 20 mm beträgt.

4. Einbaumodul (12) nach einem der Ansprüche 1 bis 3, dadurch gekennzeichnet, dass die Gegenstücke (30,32) als Stecker und Steckdose, Stiften- und Buchsenleiste oder als Federleisten ausgebildet sind.

5. Einbaumodul (12) nach Anspruch 4, dadurch gekennzeichnet, dass die Steckdose/n, die Buchsenleiste/n und/ oder die eine/n Federleiste/n fest eingebaut, der/die Stecker, die Stiftenleiste/n und/oder die andere/n Federleiste/n verschieb- und arretierbar angeordnet sind.

6. Einbaumodul (12) nach einem der Ansprüche 1 bis 5, dadurch gekennzeichnet, dass die verschiebbaren Gegenstücke (30,32) der Steckverbindung eine sich entlang einer Ebene (E1,E2) schräg oder in einer Ebene (E3) parallel zur Rückwand (18) über die Höhe (h) des Moduls erstreckende Steckerhülse (34) mit Führungsfunktion haben.

7. Einbaumodul (12) nach einem der Ansprüche 1 bis 5, dadurch gekennzeichnet, dass die verschiebbaren Gegenstücke (30,32) der Steckverbindung eine entlang einer Ebene (E1,E2,E3) verlaufende Teleskopführung (46) und vorzugsweise eine sich über die Höhe (h) des Moduls erstreckende Steckerhülse (34) ohne Führungsfunktion haben, wobei Teleskopführung (46) und Steckerhülse (46) schräg oder parallel zur Rückwand (18) verlaufen.

8. Einbaumodul (12) nach einem der Ansprüche 1 bis 7, dadurch gekennzeichnet, dass das eine der paarweise angeordneten Gegenstücke (30,32) der Steckverbindung wenigstens einen verriegelbaren Führungsstift (36), das andere Gegenstück (32,30) wenigstens eine entsprechende Bohrung (40) zur Aufnahme des zugeordneten Führungsstifts (36) hat.

9. Einbaumodul (12) nach einem der Ansprüche 1 bis 8, dadurch gekennzeichnet, dass die verschiebbaren Gegenstücke (30,32) ein Rückführungsorgan, vorzugsweise zwei Federn (44), haben.

10. Einbaumodul (12) nach einem der Ansprüche 1 bis 9, dadurch gekennzeichnet, dass die Gegenstücke (30,32) der Steckverbindung im Bereich der Rückseite (18) angeordnet sind, das verschiebbare Gegenstück nach innen verschiebbar und von aussen ohne Demontage eines benachbarten Einbaumoduls (12) zugänglich ist.

11. Modulaufbau (10) aus gestapelten, im Bereich der Ecken lösbar verschraubten Einbaumodulen (12) nach einem der Ansprüche 1 bis 10 aus einem stabilen Schutzgehäuse aus Leichmetall und einer zur Schock- und Vibrationsabsorption über elastische Puffer, vorzugsweise über vier schräg an den Ecken montierte Gummipuffer, gelagerten Bodenplatte (22).
